# EUROPÄISCHE PATENTANMELDUNG

(11) **EP 2 323 177 A1**
(43) Veröffentlichungstag der Anmeldung: **18.05.2011**
(21) Anmeldenummer: 11075031.2
(22) Anmeldetag: 18.10.2006
(51) Int. Cl.: H01L 31/101, H01L 31/105, H01L 23/66

(54) **Photodioden-Chip hoher Grenzfrequenz**

(30) Priorität: 21.10.2005 DE 102005051571
(62) Teilanmeldung aus: 06805465.9
(71) Anmelder: Fraunhofer Gesellschaft zur Förderung der angewandten Wissenschaft E.V., 80686 München (DE)
(72) Erfinder: Bach, Heinz-Günter, 14163 Berlin (DE); Beling, Andreas, Charlottesville, VA 22903 (US)
(74) Vertreter: Pfenning, Meinig & Partner GbR

(57) **Zusammenfassung**

Die Erfindung betrifft einen Photodioden-Chip hoher Grenzfrequenz mit einem Leitungsübergang vom aktiven Photodiodenbereich eines Photodioden-Mesas zum Ausgangs-Pad des Hochfrequenzausgangs des Photodioden-Chips.
Es bestand Bedarf, beim Bandbreitefaktor von Photodioden-Chips nach weiteren Steigerungen zu suchen.
Vorgeschlagen wird hierzu, dass die Verbindung vom Photodioden-Mesa zum Ausgangs-Pad mit einer hochohmigen Leitung mit über deren Länge verteilter Impedanz (Z_{leitung}) realisiert ist, die mindestens so hoch ist wie die am Ausgangs-Pad wirksame Lastimpedanz (Zₗₐₛₜ). Die hochohmige Leitung besitzt eine Länge, die über das technologische Mindestmaß von etwa 30μm hinausgeht.

## Beschreibung

Die Erfindung betrifft einen Photodioden-Chip hoher Grenzfrequenz mit einem Leitungsübergang vom aktiven Photodiodenbereich eines Photodioden-Mesas zum Ausgangs-Pad eines Hochfrequenzausgangs des Photodioden-Chips. Dabei kann auf dem Chip vorteilhaft, aber nicht notwendigerweise, eine Abschlussimpedanz mit integriert sein.

Für Ultrabreitband-Photodioden ist das Quantenwirkungsgrad-Bandbreiteprodukt ein wesentliches Qualitätsmerkmal, welches für Frequenzen oberhalb von 40 GHz in der Regel nur durch Kompromisse im Design (Quantenwirkungsgrad vs. Transitzeitlimitierung vs. RC-Limitierung) entworfen werden kann. Dieser Designkompromiss wird bei fortgeschrittenen integrierten Bauformen von Zweidioden-Detektoren (Balanced Detektor) besonders kritisch, da hier durch die Parallelschaltung zweier Photodioden eine verdoppelte Kapazität in die RC-Limitation eingeht.

Bisher wurde der bei Photodioden bekannte Kompromiss zwischen Transitzeit begrenzter Bandbreite und Absorptions-Quantenwirkungsgrad bei den immer höher benötigten Betriebsgrenzfrequenzen (10 GHz hin zu 50 GHz) dadurch gelöst, dass von der Bauform der senkrecht beleuchteten Photodiode zur seitlich beleuchteten Photodiode übergegangen wurde. Derartige Photodioden sind zum Beispiel aus DE 100 44 521 A1 bekannt. Damit konnte bei Einzelphotodioden der Frequenzbereich von bisher 15 GHz hin zu typisch 65 GHz bei möglichst hoch zu erhaltender Responsivität um 0,7 A/W erschlossen werden. Oberhalb von 65 GHz ist auch beim seitlich beleuchteten Photodiodenkonzept, sowohl in den Unterbauformen der Wellenleiterphotodiode wie der evaneszent beleuchten Photodiode erneut ein kritischer Kompromiss zwischen Wirkungsgrad und Bandbreite einzugehen, so dass Bedarf bestand, beim Bandbreitefaktor nach weiteren Steigerungen zu suchen.

Die hier betrachteten Photodioden sind mit einer integrierten Lastimpedanz abgeschlossen, zum Beispiel 50 Ohm, nach außen parallel beschaltet, womit die Signalintegrität deutlich verbessert wird. Dies basiert am Ort der Photodiode auf der Unterdrückung von Reflexionen, die zuvor von einer Folgeelektronik zur Photodiode reflektiert werden konnten.

In der Literatur ist die Anhebung der Bandbreite bei Photodioden durch das sogenannte "induktive Peaking" wohl bekannt, siehe Kato et al., Design of Ultrawide-Band, High-Sensivity p-i-n Photodetectors, IEICE Trans. Electron. Vol. E76-C, No. 2, Febr. 1993, S. 214-221. Hierbei wird der kapazitiven Stromquelle (pn-Übergang der Photodiode) eine kleine Induktivität in Serie geschaltet (typischerweise ein Bonddraht). Wenn diese Ersatzschaltung ihre elektrische Energie in einen ohmschen Lastwiderstand einspeist, kann die RC-Bandbreite, die ohne die Induktivität durch 1/2π R_{ges}C_{ges} gegeben war, gegenüber diesem RC-Limit um bis zu einem Faktor von ca. √2 erhöht werden (Serienresonanzeffekt). Der Nachteil dieser Methode ist, dass die gewünschte Bandbreitenerhöhung mit einer stark nichtlinearen Phasendrehung über der Frequenz, insbesondere in der Nähe der oberen Grenzfrequenz, erkauft wird.

Aufgabe der Erfindung ist es, eine passive Photodioden-Beschaltung anzugeben, deren Bandbreite bei Einfachdioden auf über 100 GHz und deren Bandbreite bei Balanced Detektoren auf über 70 GHz gesteigert werden kann, ohne dass die Responsivität sinkt, das heißt ohne eine Flächen- oder Längenverringerung der Photodiode in Kauf zu nehmen. Ziel der Erfindung ist dabei nicht nur die Kontrolle des Frequenzgangs eines alleinigen Photodioden chips, sondern auch die reproduzierbare Einstellung des Frequenzgangs eines Detektormoduls, welches einen monolithischen Photodiodenchip als Hauptbestandteil enthält.

Erfindungsgemäß wird die Aufgabe gelöst durch die Merkmale des Anspruchs 1. Zweckmäßige Ausgestaltungen sind Gegenstand der Unteransprüche.

Danach ist die Verbindung vom Photodioden-Mesa zum Ausgangs-Pad mit einer hochohmigen Leitung mit einer über deren Länge verteilter Impedanz realisiert, die mindestens so hoch ist wie die effektive Lastimpedanz. Die effektive Lastimpedanz ist beispielsweise die am Chipausgang seitens der Photodiode gesehene Parallelschaltung aus der chip-externen Lastimpedanz (häufig um 50 Ohm) und der oft on-chip mitintegrierten Lastimpedanz (damit ebenfalls häufig um 50 Ohm).

In erfindungsgemäß bevorzugter Weise ist die Impedanz der hochohmigen Leitung mindestens doppelt so hoch wie die effektive Lastimpedanz.

Die Bandbreite wird dadurch gesteigert, dass bei den beiden Bandbreiten begrenzenden Einflüssen Transitzeitlimitation und RC-Limitation die RC-Limitation durch eine impedanzkontrollierte Leitungsführung vom pin-Mesa der Diode hin zum gegebenenfalls widerstandsbelasteten Ausgangs-Pad kontrolliert angehoben wird, so dass die resultierende Gesamtbandbreite nun durch die physikalisch limitierende Transitzeitlimitation dominiert wird. Dabei wird auf die Erhaltung einer kurzen, überschwingungsarmen Pulsantwort Wert gelegt, die für die digitalen Signalformen der nachrichtentechnischen Anwendungen wichtig ist.

Grundgedanke ist es, die gewünschte Amplitudenanhebung über einen größeren Frequenzbereich moderat zu verteilen, um die nichtlineare Phasendrehung über größere Frequenzbereiche zu verschmieren und somit auch die für das Pulsverhalten relevante Gruppenlaufzeitstreuung nicht unmäßig zu erhöhen, wie es bei einem Ansatz mittels eines diskreten RLC-Serienschwingkreises leicht der Fall ist.

Die Erfindung setzt daher auch beim Grundmechanismus des induktiven Peakings an, realisiert aber die frequenzgangsanhebende serielle Induktivität nicht als diskretes Element, sondern benutzt eine, im Vergleich zur Lastimpedanz (üblich sind 50 Ohm) hochohmige Leitung mit zum Beispiel 100...150 Ohm Wellenwiderstand.

Untersuchungen im Schaltungssimulator ergaben, dass der gewünschte Pegel anhebende Effekt im Frequenzbereich der RC-Limitation auftritt; jedoch fällt ein mögliches Überschwingen im Frequenzbereich des Amplitudenganges verschliffener und moderater aus, so dass auch die Gruppenlaufzeitschwankung geringer ausfallen kann.

Die praktische Realisierung der Erfindung wird bei monolithisch integrierten Photodioden mit sehr hoher Grenzfrequenz (40 GHz und höher) dadurch begünstigt, dass die Leitungsführung auf einem Chip, herunter vom pn-Mesa hin zum Ausgangs-Pad, nicht mehr durch diskrete induktive Elemente, sondern durch verteilte Leitungselemente vorgenommen wird. Selbst kurze Luftbrücken einiger 10 µm Länge vom pn-Mesa herunter auf die Metallebene besitzen verteilte Streukapazitätselemente einiger fF zum Substrat hin, so dass derartige Luftbrücken als hochohmige Leitungen (Z=√L/C) beschrieben werden müssen und nicht mehr durch diskrete Induktivitäten. Eine L-C-verteilte Leitung kann somit in der einfachsten und elegantesten Form durch eine Verlängerung der Luftbrücke über das technologisch nötige Mindestmaß hinaus gebildet werden und in Fällen von zum Beispiel Zweidioden-Empfängern, bei denen beide Dioden nach Zusammenführung ihrer Elektroden vom Pegel-anhebenden Effekt profitieren sollen, durch eine dingliche Mikrostreifen- oder Koplanarleitung geeigneter hochohmiger Impedanz realisiert werden.

Das Problem besteht darin, zwar eine nennenswerte Frequenzgangverlaufsanhebung zu erzielen, ohne jedoch die Pulsantwort durch zuviel Überschwingen unangemessen zu benachteiligen. Dies wird durch den verteilten Leitungsansatz im Vergleich zur diskreten Realisierung (eines einzelnen Induktivitätswerts) ermöglicht, weil hier zwei Optimierungsparameter (Impedanz und Leitungslänge) zur Verfügung stehen. Dabei ist das Ausmaß der Frequenzgangsanhebung sorgsam an die beiden, am Photodiodenchip wirksamen Mechanismen anzupassen: die RC-Limitation (der gesamten Umfeldbeschaltung) und die Transitzeitlimitation (im pn-Mesa).

Die Transitzeit-Limitation gibt die letztlich höchstmögliche Bandbreite an, die überhaupt erzielt werden kann, wenn die RC-Limitation durch beliebige Flächenverkleinerung gegen quasi unendlich hochgesetzt würde. Eine Frequenzgangsanhebung über die äquivalente Transitzeit-Grenzfrequenz ist daher zu vermeiden. Wohl aber kann sinnvoll der aus beiden Grenzeinflüssen resultierende Gesamtfrequenzgang an das Transitlimit herangeführt werden, so dass das RC-Limit praktisch weitgehend aufgehoben wird. Geschieht dies mit der erfindungsgemäßen Frequenzband verschmierenden Methode durch verteilte Elemente, kann weiterhin mit einem guten Impulsverhalten gerechnet werden.

Der hier beschriebene und erprobte Mechanismus ist sowohl auf seitlich beleuchtete Photodioden als auch auf alle Bauformen diskreter Photodioden mit senkrechter Beleuchtung anwendbar. Dabei kann die Photodiode wahlfrei vom pn/pin-Typ oder vom MSM (metal-semiconductor-metal)-Typ aufgebaut sein.

Die Erfindung soll nachstehend anhand eines Ausführungsbeispiels einer wellenleiter-integrierten Photodiode näher erläutert werden. In den zugehörigen Zeichnungen zeigen:
- Fig. 1: eine Photodiode schematisch in einem Querschnitt,
- Fig. 2: das elektrische Ersatzschaltbild der Photodiode mit ihrer Umfeldbeschaltung: a) konventionelles induktives Peaking b) erfindungsgemäße Frequenzgangsanhebung und Kontrolle mittels einer kurzen hochohmigen Leitung,
- Fig. 3: den simulierten Frequenzgang (a), die Gruppenlaufzeit (b) und Pulsantwort (c) einer pin-Photodiode gemäß Fig. 2b) bei Variation der Luftbrückenleitungslänge,
- Fig. 4: den gemessenen Frequenzgang der optoelektronischen Leistungskonversion eines wellenleiter-integrierten Photodioden-Chips der nominellen Abmessungen 5 x 20 µm²,
- Fig. 5: einen Balanced Photodiodenchip mit 70 GHz Bandbreite (Layout)
- Fig. 6: die optoelektrischen Leistungsfrequenzgänge eines Balanced Photodetektor-Chips mit einem elektrischen Leiterbahn-Layout kontrollierter Impedanz mittels hochohmiger Koplanarleitung,
- Fig. 7: ein elektrisches Augendiagramm für ein Detektormodul gemäß Fig. 1 bei 80 Gbit/s und
- Fig. 8: ein elektrisches Augendiagramm für ein Detektormodul gemäß Fig. 1 bei 100 Gbit/s.

Die Photodiode ist auf einem InP-Substrat 1 epitaktisch aufgebaut und besteht bei diesem Beispiel aus einem Zuführungswellenleiter 2 und einem Photodioden-pin-Mesa auf Basis von InGaAs/InGaAsP, bestehend aus einer leitfähigen n-Kontaktschicht 3, einer Absorberschicht 4 und einer p-Kontaktschicht 5. Die Absorberschicht 4 des Photodioden-Mesas 4 hat eine Grundfläche von 5 x 20 µm². Die Dicke der Absorberschicht 4 liegt in der Größenordnung von 350 nm. Der Zuführungswellenleiter 2 ist ein Rippenleiter von 2 µm Breite.

Die leitfähige n- Kontaktschicht 3 befindet sich zwischen dem Zuführungswel lenleiter 2 und der Absorberschicht 4. Die n-Kontaktschicht 3 ist in Richtung des Zuführungswellenleiters 2 um die Länge L, die einige µm beträgt, verlängert. In der p-Kontaktschicht 5 sind mehrere p-leitende Heterostrukturschichten inklusive der p-Metall-Kontaktschicht zusammengefasst. Die pin-Photodiode wird demgemäß zwischen der p-Kontaktschicht 5 und der n-Kontaktschicht 3 nach außen angeschlossen.

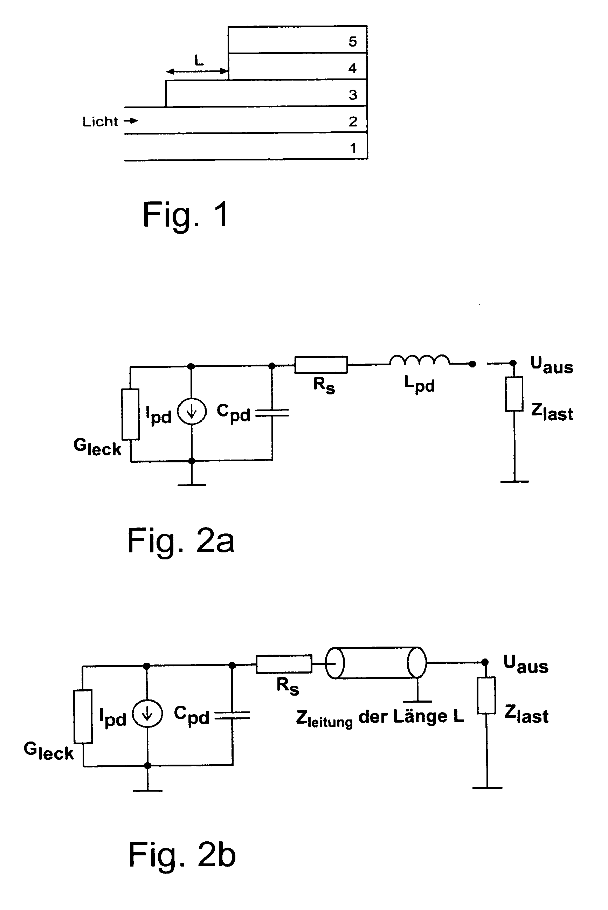

Fig. 2a zeigt das Ersatzschaltbild einer Photodiode (C_{pd}, I_{pd}, G_{leck}, Rₛ) mit dem bekannten induktiven Peaking mittels einer konzentrierten seriellen Induktivität L_{pd}, die das Photodiodensignal in eine Lastimpedanz Zₗₐₛₜ einspeist. Die Lastimpedanz Zₗₐₛₜ ist entweder identisch zur externen Last (häufig 50 Ohm) oder beinhaltet die zusätzliche Parallelschaltung einer auf dem Chip mitintegrierten Abschlußimpedanz (auch um 50 Ohm). Uₐᵤₛ kennzeichnet die Ausgangsspannung am Lastwiderstand.

Fig. 2b zeigt die erfindungsgemäße Umfeldbeschaltung der Photodiode zur kontrolliert gesteuerten Frequenzgangsanhebung mittels einer kurzen hochohmigen Leitung der Impedanz Z_{leitung} und der Länge L. Die Leitung hat eine verteilte Impedanz von ca. 130 Ohm und eine Länge von 70 µm.

Die Bandbreite wird durch diese Maßnahme gesteigert, indem bei den beiden bandbreiten-begrenzenden Einflüssen: Transitzeitlimitation und RC-Limitation, die RC-Limitation durch die impedanzkontrollierte Leitungsführung vom Photodioden-Mesa der Diode hin zum 50-Ohm-Ausgangspad mittels einer als Leitung wirkenden Luftbrücke, die eine über das technologisch nötige Maß (von ca. 30 µm) erhöhte Länge besitzt, kontrolliert nach oben angehoben wird, so dass die resultierende Gesamtbandbreite nun durch die physikalisch limitierende Transitzeitlimitation dominiert wird.

Im Ergebnis einer Schaltungssimulation konnte bei Realisierung dieser Maßnahme eine Frequenzganganhebung um ca. 30 bis 40 % nachgewiesen werden, bei Erhaltung eines monoton flachen Frequenzganges der Photodiode.

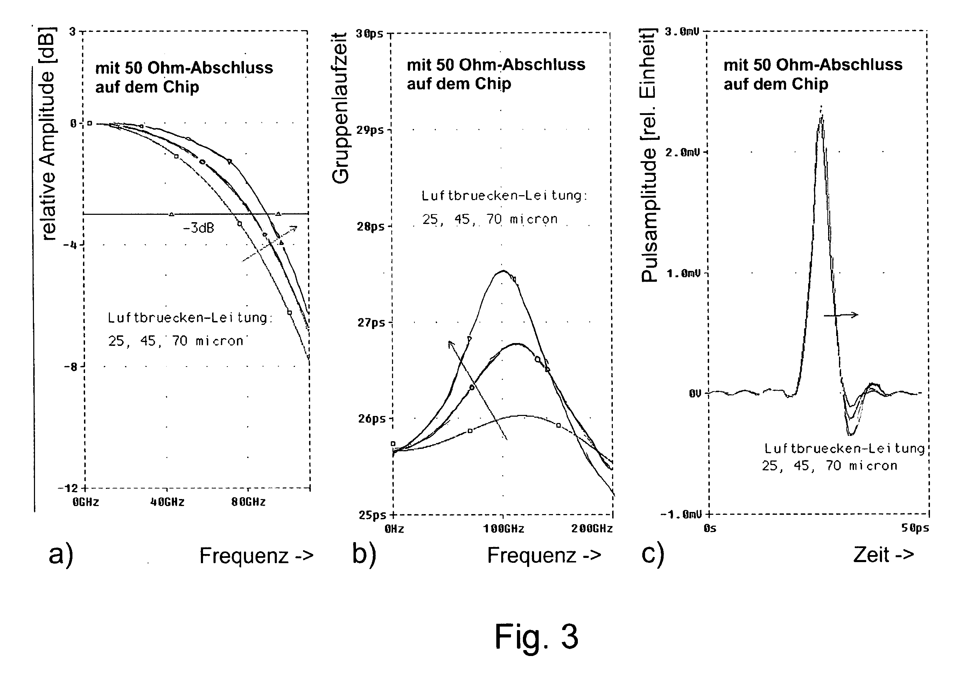

Fig. 3a zeigt den Frequenzgang bei einer Variation der Luftbrückenleitungs länge von 25 µm (unterste Kurve) auf 70 µm (oberste Kurve). Die hochohmige Leitung wird hierbei neben ihrer kleinen parasitären Streukapazität im fF-Bereich ausgedrückt über ihre äquivalente Längsinduktivität (14 pH - 42 pH).

Bei entsprechend reduziertem Serienwiderstand im 5 Ohm-Bereich ist eine weitere Frequenzganganhebung bis zu einer noch höheren 3 dB-Frequenzgrenze von sogar 100 GHz möglich.

Fig. 3 b zeigt zur Veranschaulichung der Maßnahmen die Auswirkung auf die Gruppenlaufzeit, die sich unter 2 ps Streuung hält (also unter 20 % der Bitperiode eines 100 Gbit/s Signals). Fig. 3 c zeigt die Pulsantwort des Detektors, wobei das Nachschwingen für die größte Bandbreite unter 15 % des Pulsmaximums bleibt.

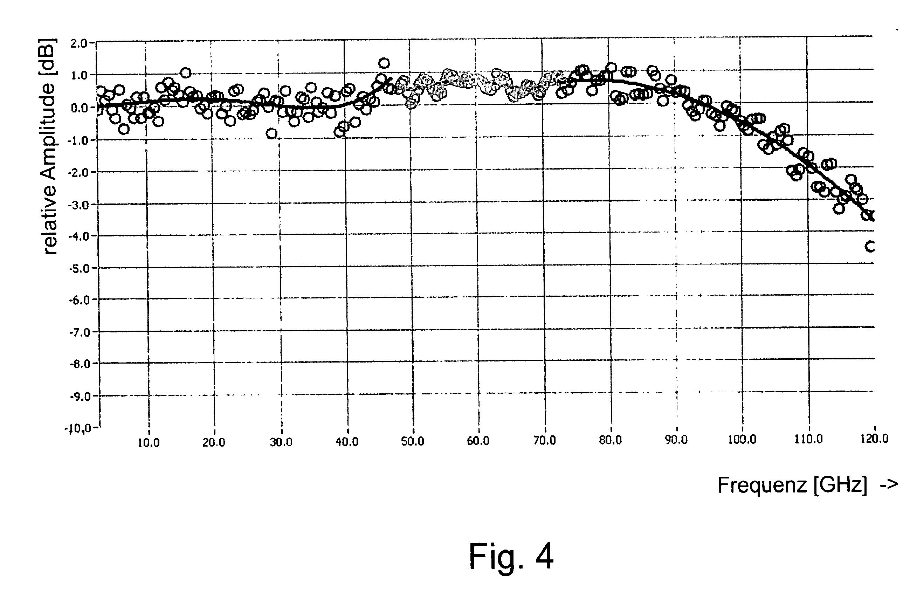

Diese Frequenzganggrenze konnte in der Praxis durch moderates Unterätzen im µm-Bereich einer nominell 5 x 20 µm² großen Photodiodenfläche sogar bis zu 110 GHz angehoben werden (Fig. 4).

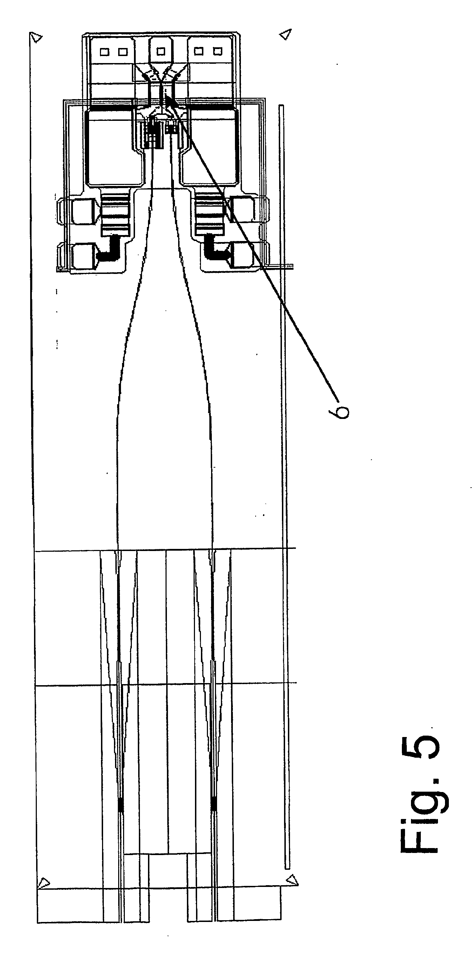

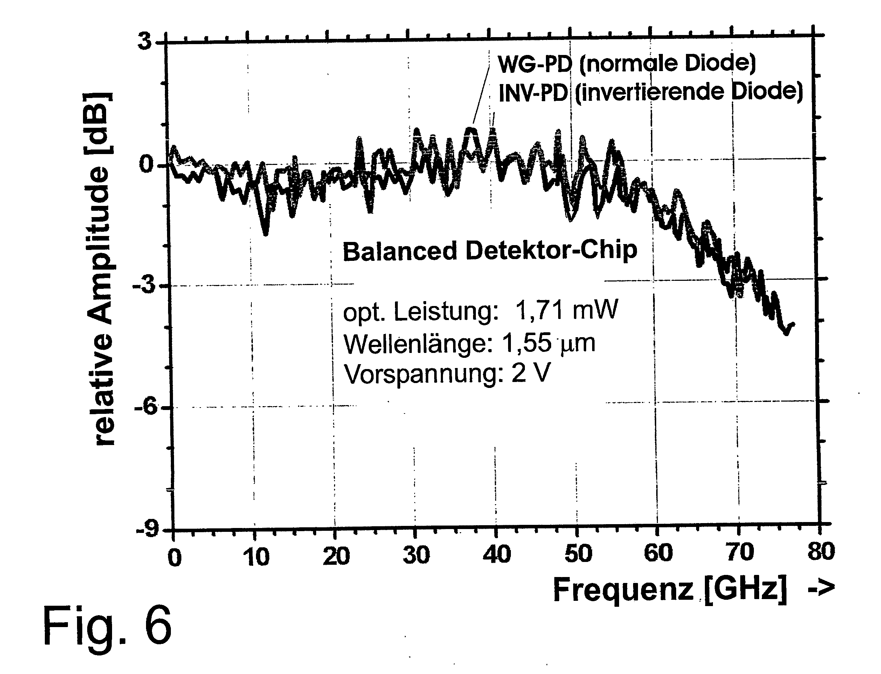

Dasselbe Prinzip, auf die Bauform von Balanced Detektoren (Fig. 5) angewandt, die bislang eine Bandbreite von 40 - 45 GHz aufwiesen, führte nach dem Einbringen der impedanzkontrollierten Leitungsführung vom Vereinigungspunkt beider parallel geschalteter Photodioden bis hin zum 50-Ohm-Abschlusswiderstand über eine hochohmige Koplanarleitung 6 zu einer Steigerung der Bandbreite auf 70 GHz, siehe die Fig. 6.

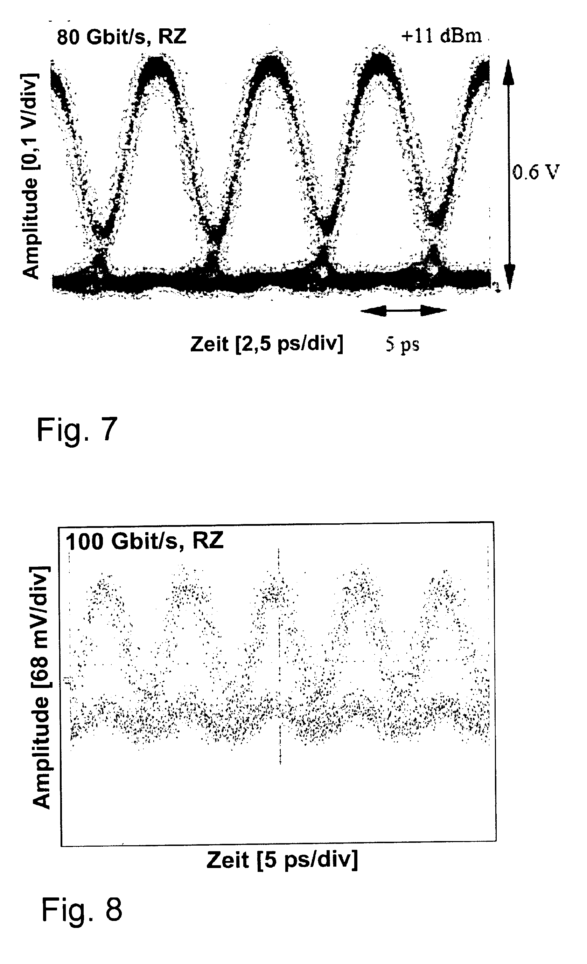

Zum Beleg der ausgezeichneten elektrischen Ausgangspulsformen, die sich unter Anwendung dieses Chip-Designprinzips erzielen lassen, zeigen die Fig. 7 und 8 anhand eines aufgebauten Detektormoduls mit einem Breitbandphotodioden-Chip gemäß Fig. 1 Augendiagramme für das RZ-Modulationsformat, welche bei 80 Gbit/s und 100 Gbit/s aufgenommen wurden. Fig. 7 zeigt ein 80 Gbit/s RZ Augendiagramm bei +11 dBm optischer Eingangsleistung, konvertiert von einem Photodetektormodul unter 2,5 V Sperrspannung: x-Achse: 2.5 ps/div, y-Achse: 100 mV/div, Fig. 8 ein O/Ekonvertiertes 100 Gbit/s RZ-Datensignal mit 2²⁰-1 PRBS Statistik, detektiert mit einem Photoempfängermodul C05-W16 und einem 100 GHz-Oszilloskop SE100 (LeCroy) bei optischen RZ-Pulsen mit 2,4 ps Pulsbreite; x: 5ps/div, y: 68 mV/div. In beiden Fällen ist eine gute Durchmodulation auf die Null-Linie zu erkennen, die die hohe Bandbreite im 100 GHz-Bereich auch im aufgebauten Modul belegt. Weiterhin sind die auf die "Eins" nachfolgenden Nachschwing effekte so gering, dass für beide Bitraten weit geöffnete Augen gemessen werden konnten.

Ein Vergleich der RZ-Augendiagramme (Fig. 7, 8) am fertigen Modul mit der Pulsform des Chips in der Fig. 3 c zeigt, dass am realen Modul weniger Überschwingen in den Nullen der RZ-Folgen vorliegt, als man vom Pulsbild des Chips erwarten könnte. Dieser günstige Einfluss der Aufbautechnik des Moduls auf die Pulsform ist nicht unerwartet, sondern wurde beim Design des Chips bereits einbezogen. Die im Modul verwendete kurze Verbindungsleitung zwischen Chip und dem 1mm-Stecker hat ihrerseits eine kleine Dämpfung zwischen 0,5 - 1 dB im Frequenzbereich hin zu 100 GHz. Um diese mit der Frequenz zunehmende Dämpfung vorausschauend mit dem Frequenzgang des Chips auszugleichen, wurde für den Chip mit der erfinderischen Maßnahme ein leicht ansteigender Frequenzgang um 70 GHz herum vorgesehen, wie ihn die Messung in der Fig. 4 zeigt. Zusammen mit der Dämpfung der modulinternen Verbindungsleitung entsteht für das Modul dann ein monoton sanft abfallender Frequenzgangsverlauf, der im Idealfall einem Besselfilter 4. Ordnung ähneln soll, um so für das Gesamtsystem eine möglichst ideale Impulsform bei maximaler Bandbreite zu erzielen. Da die Erfindung die Frequenzgangskontrolle in Form einer monolithischen Integration on-chip vorsieht, ist nur mit geringen Streuungen im fertigen Modulaufbau zu rechnen, da keine kritischen Bonddrahtschleifen mit exakter Höhenkontrolle notwendig sind (wie beim bekannten induktiven Peaking); es wird sogar im Gegenteil im Modulaufbau angestrebt, die Bondverbindungen stets ideal kurz und mittels Mehrfachbondung sehr induktivitätsarm auszuführen, da die gesamte Frequenzgangskontrolle dem monolithischen Chip obliegt, der lithographisch präzise reproduzierbar gefertigt werden kann.

## Patentansprüche

1. Photodioden-Chip hoher Grenzfrequenz mit einem einen aktiven Photodiodenbereich aufweisenden Photodioden-Mesa (5, 4, 3), einem Zuführungswellenleiter (2), einem den Hochfrequenzausgang bildenden Ausgangs-Pad (Vₒᵤₜ) und einem Leitungsübergang vom Photodioden-Mesa (5, 4, 3) zum Ausgangs-Pad (Vₒᵤₜ),,
**dadurch gekennzeichnet, dass**
der Leitungsübergang mit einer hochohmigen Leitung mit über deren Länge verteilter Impedanz (Z_{leitung}) realisiert ist, die mindestens so hoch ist wie die am Ausgangs-Pad wirksame Lastimpedanz (Zₗₐₛₜ), wobei die hochohmige Leitung eine über das technologisch nötige Mindestmaß von etwa 30 µm erhöhte Länge besitzt und der Photodioden-Chip eine Grenzfrequenz von größer 40 GHz aufweist

2. Photodioden-Chip nach Anspruch 1,
**dadurch gekennzeichnet, dass**
eine dem Ausgangs-Pad parallel-geschaltete Abschlussimpedanz auf dem Chip zur Reflexionsminderung mitintegriert ist.

3. Photodioden-Chip nach Anspruch 2,
**dadurch gekennzeichnet, dass**
die Impedanz (Z_{leitung}) der hochohmigen Leitung mindestens doppelt so hoch wie die effektive Lastimpedanz (Zₗₐₛₜ)ist, die aus der äußeren Lastimpedanz und der mitintegrierten Abschlussimpedanz gebildet ist.

4. Photodiode nach einem der vorhergehenden Ansprüche,
**dadurch gekennzeichnet, dass**
die Impedanz (Z_{leitung}) der hochohmigen Leitung durch eine streukapazitätsbelastete Luftbrücke realisiert ist.

5. Photodiode nach einem der Ansprüche 1 bis 3,
**dadurch gekennzeichnet, dass**
die Impedanz (Z_{leitung}) der hochohmigen Leitung durch eine Koplanarleitung (6) realisiert ist.

6. Photodiode nach einem der Ansprüche 1 bis 3,
**dadurch gekennzeichnet, dass**
die Impedanz (Z_{leitung}) der hochohmigen Leitung durch eine Mikrostreifenleitung realisiert ist.

7. Photodiode nach Anspruch 5 oder 6,
**dadurch gekennzeichnet, dass**
die Photodiode als Zwei-Dioden-Detektor, vorzugsweise als Balanced Detektor, realisiert ist.

8. Photodiode nach einem der vorhergehenden Ansprüche,
**dadurch gekennzeichnet, dass**
der Zuführungswellenleiter (2) als seitlich beleuchteter Zuführungswellenleiter ausgebildet ist.

9. Photodiode nach einem der vorhergehenden Ansprüche,
**dadurch gekennzeichnet, dass**
der Photodioden-Mesa auf der Basis von InGaAs/InGaAsP aufgebaut ist und eine n-Kontaktschicht (3), eine Absorberschicht (4) und eine p-Kontaktschicht (5) aufweist.

10. Photodiode nach Anspruch 9,
**dadurch gekennzeichnet, dass**
die Absorberschicht (4) eine Grundfläche von 5x20 µm² und eine Dicke in der Größenordnung von 350 nm aufweist.

11. Photodiode nach Anspruch 4 und einem der Ansprüche 8 bis 10,
**dadurch gekennzeichnet, dass**
die Grenzfrequenz im Fall einer mitintegrierten Abschlussimpedanz von 50 Ohm bei einer Luftbrücke mit einer Länge von 45 µm etwa 77 GHz und mit einer Länge von 70 µm etwa 95 GHz bei -3 dB Abfall beträgt.
